# EUROPEAN PATENT APPLICATION

(11) **EP 4 845 357 A1**
(43) Date of publication of application: **25.11.2026**
(21) Application number: 26180103.9
(22) Date of filing: 21.05.2026
(51) Int. Cl.: H10F 77/20, H10F 10/14, H10F 10/165, H10F 71/00, H10F 77/70

(54) **SOLAR CELL AND PREPARATION METHOD THEREOF**

(30) Priority: 21.05.2025 CN 202510660545
(71) Applicant: Ja Solar Technology Yangzhou Co., Ltd., Yangzhou, Jiangsu 225131 (CN)
(72) Inventor: ZHOU, Chao, Fengtai District, Beijing 100160 (CN); LYU, Chen, Fengtai District, Beijing 100160 (CN); LYU, Pengfei, Fengtai District, Beijing 100160 (CN)
(74) Representative: Sun, Yiming

(57) **Abstract**

The present invention provides a solar cell and a preparation method thereof. The solar cell comprises a silicon substrate, wherein the front surface of the silicon substrate is provided with a textured structure, the front surface of the silicon substrate is divided into a working region and an edge isolation region, the working region comprises a p-type emitter, a first passivation layer and a first electrode which are sequentially arranged on the front surface from inside to outside, and the edge isolation region comprises the first passivation layer arranged on the front surface; a tunneling oxide layer, an n-type doped polysilicon layer, a second passivation layer and a second electrode are sequentially arranged on the back surface of the silicon substrate from inside to outside, wherein the reflectivity of the textured structure in the working region is R1, the reflectivity of the textured structure in the edge isolation region is R2, R1/R2 is within the range of 0.3-3, and the distance between the textured structure substrate of the working region and the textured structure substrate of the edge isolation region is within the range of 3 µm -10 µm.

## Description

### Cross-reference to related applications

The present application claims priority from the Chinese patent application with application number 202510660545.3, filed on May 21, 2025 and titled "Solar cell and preparation method thereof". The disclosure of this Chinese patent application is incorporated in its entirety herein by reference.

### Technical Field

The present invention relates to the technical field of solar cell, particularly to solar cell and preparation method thereof.

### Background Art

TOPCon (Tunnel Oxide Passivated Contact) solar cells significantly reduce carrier recombination losses through the synergistic passivation effect of the ultrathin tunnel oxide layer and doped polysilicon layer on the back side, achieving high open-circuit voltage and high conversion efficiency. However, to meet the technical requirements of half-cell technology at the module end, cells need to be divided into segments via laser cutting. The surface of the silicon substrate exposed at the cutting cross-section forms dangling bonds and defect states due to laser thermal damage. These dangling bonds and defect states act as strong recombination centers for carriers, resulting in a 0.1%-0.2% efficiency loss of the segmented cells and restricting the power output of the module.

To address the above issues, various optimization approaches have been attempted in the prior art. Currently, the mainstream edge passivation technology in the industry uses Atomic Layer Deposition (ALD) to coat an aluminum oxide passivation layer on the cutting surface. Although this can improve module power, it requires the introduction of high-temperature annealing and specialized equipment, leading to high process costs. Additionally, the problem of winding plated passivation layer is prominent, which affects the consistency of cell appearance. The patent application with publication number CN118507594A discloses a scheme of "setting polished surface isolation regions on both sides of the cutting area". It reduces recombination by physically blocking the lateral migration path of carriers. However, the reflectivity of the polished surface is as high as 30%-40%, which causes partial light loss and reduces the short-circuit current of the cell. Meanwhile, laser damage is difficult to remove, resulting in poor passivation of the isolation regions and darkening of PL images, which impairs the open-circuit voltage of the cell. Although the patent application with publication number CN119029092A discloses a nanosecond laser etching and stepwise cleaning process, which improves passivation by forming a planar or textured structure and adjusts the surface morphology of the isolation region by modifying the spot overlap rate, this technology is complex to operate. Furthermore, the inventors of the present application found that when using an alkaline solution to remove the residual boron emitter in the isolation region, the boron emitter in the working region is also damaged, thereby affecting the light absorption rate and short-circuit current of the solar cell.

Therefore, there is an urgent need in the industry to develop a novel TOPCon solar cell structure and its preparation method, which can block the carrier recombination channels while maintaining high light absorption rate and short-circuit current.

### Contents of the Invention

To address the issues of low light utilization efficiency and low short-circuit current in segmented cells with isolation regions in the prior art, the present invention provides a solar cell and a preparation method thereof.

A first aspect of the present application is to provide a solar cell, comprising a silicon substrate, wherein the front surface of the silicon substrate is provided with a textured structure, the front surface of the silicon substrate is divided into a working region and an edge isolation region, the working region comprises a p-type emitter, a first passivation layer and a first electrode which are sequentially arranged on the front surface from inside to outside, and the edge isolation region comprises the first passivation layer arranged on the front surface; a tunneling oxide layer, an n-type doped polysilicon layer, a second passivation layer and a second electrode are sequentially arranged on the back surface of the silicon substrate from inside to outside, wherein the reflectivity of the textured structure in the working region is R1, the reflectivity of the textured structure in the edge isolation region is R2, R1/R2 is within the range of 0.3-3, and the distance between the textured structure substrate of the working region and the textured structure substrate of the edge isolation region is within the range of 3 µm -10 µm.

The solar cell with the above structure achieves multiple reflections and scattering by arranging a textured structure on the front surface, thereby reducing light reflection loss and enhancing light absorption efficiency, which in turn improves the photoelectric conversion performance of the cell. By arranging the edge isolation region, the p-type emitters are separated, so that recombination losses across the entire surface p-type emitters is reduced. The arrangement of passivation layers outside the p-type emitter and the edge isolation region can suppress surface carrier recombination, optimize light absorption and selective carrier transport, thereby improving the open-circuit voltage, short-circuit current, and overall conversion efficiency of the cell. Meanwhile, controlling the ratio of the reflectivity of the textured structures in the working region and the edge isolation region within the range of 0.3-3, on one hand, realizes the regulation of the optical properties of specific film layers, and on the other hand, this reflectivity ratio can reduce local light intensity differences, making the generation and collection of carriers more uniform and maintaining a stable carrier transport path. Controlling the distance between the textured structure substrate of the working region and the textured structure substrate of the edge isolation region within the range of 3 µm-10 µm not only cuts off the p-n junction to achieve insulation isolation, but also avoids excessive etching damage to the silicon substrate.

In any embodiment of the first aspect, the reflectivity R1 is 7%-15%. The above-mentioned low-reflectivity design of the working region can reduce the surface reflection loss of incident light, especially enhance the absorption of long-wavelength light, thereby improving the short-circuit current.

In any embodiment of the first aspect, the reflectivity R2 is 7%-30%. The control of the reflectivity of the edge isolation region within the above range not only achieves passivation contact performance, but also optimizes light utilization efficiency, while avoiding process instability caused by extreme reflectivity.

In any embodiment of the first aspect, the minimum dimension of the edge isolation region in the direction away from the working region ranges from 10 µm to 1000 µm.

In any embodiment of the first aspect, the edge isolation region is a rectangular region.

In any embodiment of the first aspect, the silicon substrate is an n-type silicon substrate. Optionally, the silicon substrate is a phosphorus-doped monocrystalline silicon wafer; optionally, the resistivity of the silicon substrate is 0.1 Ω·cm-100 Ω·cm; optionally, the thickness of the silicon substrate is 100 µm-500 µm.

In any embodiment of the first aspect, the doping concentration of the p-type emitter is 2×10¹⁸ atoms/cm³-1×10¹⁹ atoms/cm³. Optionally, the junction depth of the p-type emitter is 0.5 µm-2 µm.

In any embodiment of the first aspect, the tunnel oxide layer comprises one or more of silicon oxide, silicon nitride, and aluminum oxide.

In any embodiment of the first aspect, the thickness of the tunnel oxide layer is 0.5 nm-2.5 nm.

In any embodiment of the first aspect, the thickness of the n-type doped polysilicon layer is 100 nm-300 nm.

In any embodiment of the first aspect, the doping concentration of the n-type doped polysilicon layer is 3×10²⁰ atoms/cm³-1×10²¹ atoms/cm³.

In any embodiment of the first aspect, the first passivation layer and the second passivation layer each independently comprise at least one of aluminum oxide, silicon oxide, gallium oxide, silicon nitride, aluminum nitride, or silicon oxynitride.

In any embodiment of the first aspect, the first electrode and the second electrode each independently comprise at least one of silver, silver alloy, copper, copper alloy, nickel/copper/silver multi-layer electrode.

A second aspect of the present application is to provide a method for preparing a solar cell, comprising the following steps:
S1: Texturing the front surface of a silicon substrate to obtain a first textured surface;
S2: Preparing a p-type emitter on the front surface of the textured silicon substrate, and sequentially preparing a tunnel oxide layer and an n-type doped polysilicon layer on the back surface of the silicon substrate;
S3: Removing the p-type emitter at a preset position using green picosecond laser to form a pre-isolation region;
S4: Removing the winding plated phosphosilicate glass and winding plated phosphoborosilicate glass on the front surface by acid cleaning;
S5: Re-texturing the front surface with an alkaline solution containing a texturing additive to form a second textured surface in the pre-isolation region;
S6: Removing the borosilicate glass on the front surface and the phosphosilicate glass on the back surface by acid cleaning;
S7: Passivating the front surface and the back surface;
S8: Disposing electrodes on the front surface and the back surface respectively;
S9: Performing non-destructive laser cutting, where the cutting position is in the pre-isolation region or on one side of the pre-isolation region;

wherein, the reflectivity of the first textured surface is R1, the reflectivity of the second textured surface is R2, the ratio R1/R2 ranges from 0.3 to 3, and
the distance between the substrate of the first textured surface and the substrate of the second textured surface ranges from 3 µm to 10 µm.

In the above preparation method, the pre-isolation region formed by using green picosecond laser in step S3 cuts off the p-n junction, isolating the emitters on both sides of the isolation region, which provides space for subsequent electrode isolation and cutting. Compared with nanosecond laser, green picosecond laser can more thoroughly remove the p-type emitter in the pre-isolation region without residual p-type emitter, which can expand the processing window of the isolation region. Therefore, during the alkaline solution treatment in step S5, there is no need to remove the remaining p-type emitter in the pre-isolation region, instead, it is only necessary to use the alkaline solution to remove the winding plated n-type doped polysilicon on the front surface. At the same time, since there is no blocking of the p-type emitter in the pre-isolation region, the alkaline solution can also remove the borosilicate melt and laser damage generated in the pre-isolation region, and texture the pre-isolation region to increase the etching depth of the pre-isolation region and obtain the second textured surface, thereby reducing the light reflectivity of the isolation region, i.e., increasing the light absorption rate of the isolation region, and effectively improving the short-circuit current. The above steps cooperate with each other, which not only realizes the regional regulation of the reflectivity of the isolation region and the working region, increases the light absorption rate of the isolation region, but also avoids damage to the p-type emitter in the working region, thereby effectively improving the short-circuit current. In addition, the first textured surface and the second textured surface effectively improve the open-circuit voltage of the cell. The overall preparation method is efficient and convenient, which is conducive to mass production. Meanwhile, since the isolation region can form a controllable pyramid structure after texturing, it has higher light utilization efficiency for non-destructive laser cutting. Compared with other structures, the power of non-destructive laser cutting can be further reduced, making the cutting damage more controllable.

In any embodiment of the second aspect, the wavelength of the green picosecond laser is 532 nm or 1064 nm. Optionally, the radiant power of the green picosecond laser is 1 W-50 W. Optionally, the spot overlap rate of the green picosecond laser is 40%-80%. Optionally, the energy density of the green picosecond laser is 100 mJ/cm²-400 mJ/cm². The picosecond laser has a short pulse duration and high peak power, which can focus and release a large amount of energy in an extremely short time, thereby achieving a very efficient etching effect on the p-type emitter in the pre-isolation region with less thermal damage and mechanical damage.

In any embodiment of the second aspect, the reflectivity R1 of the first textured surface is 7%-15%.

In any embodiment of the second aspect, the reflectivity R2 of the second textured surface is 7%-30%.

In any embodiment of the second aspect, the distance between two adjacent emitters after the formation of the pre-isolation region ranges from 10 µm to 1000 µm.

In any embodiment of the second aspect, in step S4, the acid solution used for acid cleaning is an HF solution having a concentration of 5%-30%, and the acid cleaning time is 10 s-70 s.

In any embodiment of the second aspect, in step S5, the mass ratio of the alkali to the texturing additive in the alkaline solution is 1:2-5:1. Optionally, the texturing temperature is 65°C-85°C. Optionally, the texturing time is 600 s-900 s.

### Description of the Figures

The figures herein are used to provide a further understanding of the present invention and constitute a part of the present invention. The schematic examples of the present invention and their illustrations are used to explain the present invention, and do not constitute an improper limitation of the present invention. In the figures:
Figure 1 is a schematic cross-sectional structure diagram of the solar cell provided in Example 1 of the present invention.
Figure 2 shows a flow chart of the method for preparing a solar cell provided in one embodiment of the present invention.
Figure 3 is a schematic cross-sectional structure diagram of the solar cell provided in Comparative Example 1 of the present invention.
Figure 4 is a schematic cross-sectional structure diagram of the solar cell provided in Example 8 of the present invention.
Figure 5 shows planar SEM images and cross-sectional SEM images of the first textured surface and the second textured surface of the solar cell provided in Example 1 of the present invention.
Figure 6 shows planar SEM images and cross-sectional SEM images of the first textured surface and the second textured surface of the solar cell provided in Comparative Example 1 of the present invention.
Figure 7 shows planar SEM images and cross-sectional SEM images of the first textured surface and the second textured surface of the solar cell provided in Example 8 of the present invention.

### Reference signs:

1 - Silicon substrate, 2 - p-type emitter, 3 - Tunnel oxide layer, 4 - n-type doped polysilicon layer, 5 - First passivation layer, 6 - Second passivation layer, 7 - First electrode, 8 - Second electrode

### Detailed Description of Embodiments

Embodiments of the present invention will be described in detail below with reference to the accompanying figures and examples. However, those skilled in the art will understand that the following examples are only used to illustrate the present invention and should not be regarded as limiting the scope of the present invention. For those examples where specific conditions are not specified, they shall be conducted in accordance with conventional conditions or conditions recommended by the manufacturer. For reagents or instruments whose manufacturers are not specified, they are all conventional commercial products available on the market. Unless otherwise specified, all concentrations mentioned in the present application refer to mass content. Taking a 20% HF solution as an example, it means that the mass content of HF in the solution is 20%.

Unless otherwise specified, the technical terms or scientific terms used in the present application shall have the ordinary meanings understood by persons with general skills in the field to which this disclosure belongs. Unless otherwise specified, the terms such as "first", "second" and the like used in the present application do not indicate any order, quantity or importance, but are only used to distinguish different components. All steps in the present application can be carried out sequentially or randomly, and sequential operation is preferred. Unless otherwise specified, the terms "include" and "comprise" mentioned in the present application are open-ended. For example, the terms "include" and "comprise" may mean that other components not listed can also be included or comprised.

To solve the problems of low light absorption rate and low short-circuit current of TOPCon solar cells after the edge isolation region is set, the present application has conducted in-depth research and found that the direct cause is that when the residual boron emitter in the edge isolation region is removed by using an alkaline solution, the boron emitter in the working region is also damaged, which affects the light absorption rate and short-circuit current. However, since the boron emitter in the edge isolation region and the boron emitter in the working region have the same composition, it is difficult to avoid damaging the boron emitter in the working region when removing the boron emitter in the edge isolation region. To avoid this damage, the present application addresses the problem at its root, that is, the boron emitter in the pre-isolation region is completely removed during laser treatment, and the reflectivity of the edge isolation region is adjusted to match the reflectivity of the working region, thereby improving the light absorption rate. Based on this technical idea, the present application provides a solar cell and a preparation method thereof.

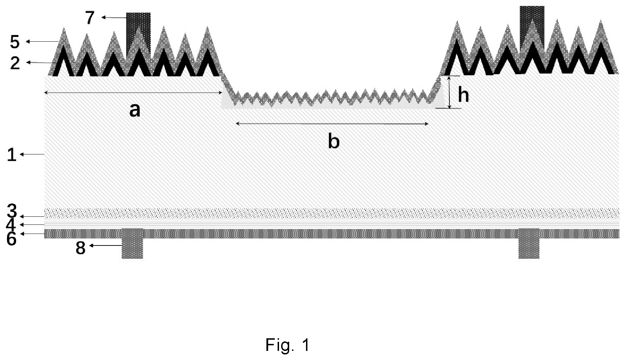

A first embodiment of the present application is to provide a solar cell. As shown in Figure 1, the solar cell comprises a silicon substrate 1, wherein the front surface of the silicon substrate 1 is provided with a textured structure, the front surface of the silicon substrate is divided into a working region and an edge isolation region, the working region comprises a p-type emitter 2, a first passivation layer 5 and a first electrode 7 which are sequentially arranged on the front surface from inside to outside, and the edge isolation region comprises the first passivation layer arranged on the front surface; a tunneling oxide layer 3, an n-type doped polysilicon layer 4, a second passivation layer 6 and a second electrode 8 are sequentially arranged on the back surface of the silicon substrate from inside to outside, wherein the reflectivity of the textured structure in the working region is R1, the reflectivity of the textured structure in the edge isolation region is R2, R1/R2 is within the range of 0.3-3, and the distance h between the textured structure substrate of the working region and the textured structure substrate of the edge isolation region is within the range of 3 µm -10 µm.

The applicant of the present application found that: in the above solar cell structure, arranging a textured structure on the front surface can reduce light reflection loss and enhance light absorption efficiency through multiple reflections and scattering, thereby improving the photoelectric conversion performance of the cell. By arranging the edge isolation region, the p-type emitters are separated , so that recombination losses across the entire surface p-type emitters is reduced. The arrangement of passivation layers outside the p-type emitter and the edge isolation region can suppress surface carrier recombination, optimize light absorption and selective carrier transport, thereby improving the open-circuit voltage, short-circuit current, and overall conversion efficiency of the cell. Meanwhile, controlling the ratio of the reflectivity of the textured structures in the working region and the edge isolation region within the range of 0.3-3, on one hand, realizes the regulation of the optical properties of specific film layers, and on the other hand, this reflectivity ratio can reduce local light intensity differences, making the generation and collection of carriers more uniform and maintaining a stable carrier transport path. Controlling the distance h between the textured structure substrate of the working region and the textured structure substrate of the edge isolation region within the range of 3 µm-10 µm not only cuts off the p-n junction to achieve insulation isolation, but also avoids excessive etching damage to the silicon substrate.

In some examples, the R1/R2 is 0.3, 0.4, 0.5, 0.6, 0.7, 0.8, 0.9, 1, 1.1, 1.2, 1.3, 1.4, 1.5, 1.6, 1.7, 1.8, 1.9, 2, 2.1, 2.2, 2.3, 2.4, 2.5, 2.6, 2.7, 2.8, 2.9, 3, or within the range of any two of the above values. In preferred examples, R1/R2 is 0.3-1.9, such as 0.3, 0.4, 0.5, 0.6, 0.7, 0.8, 0.9, 1, 1.1, 1.2, 1.3, 1.4, 1.5, 1.6, 1.7, 1.8, 1.875, 1.9, or within the range of any two of the above values.

In some examples, the reflectivity R1 is 7%-15%, such as 7%, 8%, 9%, 10%, 11%, 12%, 13%, 14%, 15%, or within the range of any two of the above values. The above-mentioned low-reflectivity design of the passivated p-type emitter can reduce the surface reflection loss of incident light, especially enhance the absorption of long-wavelength light, thereby improving the short-circuit current.

In some examples, the reflectivity R2 is 7%-30%, such as 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, or within the range of any two of the above values. The control of the reflectivity of the passivated isolation region within the above range not only achieves passivation contact performance, but also optimizes light utilization efficiency, while avoiding process instability caused by extreme reflectivity.

In some examples, as shown in Figure 1, the minimum dimension b of the edge isolation region in the direction away from the working region ranges from 10 µm to 1000 µm, such as 10 µm, 20 µm, 30 µm, 40 µm, 50 µm, 60 µm, 70 µm, 80 µm, 90 µm, 100 µm, 200 µm, 300 µm, 400 µm, 500 µm, 600 µm, 700 µm, 800 µm, 900 µm, 1000 µm, or within the range of any two of the above values. This width range design balances the isolation effect, passivation effect, and light utilization efficiency of the edge isolation region, and at the same time reserves a larger working window for laser cutting, which is conducive to improving the alignment of subsequent cutting, thereby optimizing the module efficiency, while meeting the requirements of different application scenarios for voltage resistance, appearance, and quality reliability.

In some examples, the edge isolation region is a rectangular region. The regular rectangular boundary can be precisely controlled by a laser direct writing process, which not only ensures the isolation of the p-n junction, but also facilitates matching with the vertical arrangement of grid electrodes.

In some examples, the silicon substrate is an n-type silicon substrate. In some embodiments, the n-type silicon substrate comprises a phosphorus-doped monocrystalline silicon wafer, a phosphorus-doped polysilicon wafer, an arsenic-doped monocrystalline silicon wafer, or an antimony-doped monocrystalline silicon wafer.

In some examples, the resistivity of the silicon substrate is 0.1 Ω·cm-100 Ω·cm, such as 0.1 Ω·cm, 0.2 Ω·cm, 0.3 Ω·cm, 0.4 Ω·cm, 0.5 Ω·cm, 0.6 Ω·cm, 0.7 Ω·cm, 0.8 Ω·cm, 0.9 Ω·cm, 1 Ω·cm, 5 Ω·cm, 10 Ω·cm, 20 Ω·cm, 30 Ω·cm, 40 Ω·cm, 50 Ω·cm, 60 Ω·cm, 70 Ω·cm, 80 Ω·cm, 90 Ω·cm, 100 Ω·cm, or within the range of any two of the above values. A silicon substrate within the above resistivity range helps to improve the migration speed of carriers, thereby enhancing the performance of the cell.

In some examples, the thickness of the silicon substrate is 100 µm-500 µm, such as 100 µm, 150 µm, 200 µm, 250 µm, 300 µm, 350 µm, 400 µm, 450 µm, 500 µm, or within the range of any two of the above values. A too-thin silicon substrate may lead to insufficient light absorption, while a too-thick substrate may increase resistance loss. By selecting the appropriate thickness of the silicon substrate within the above range, the balance between light absorption and current collection efficiency is achieved.

In some examples, the doping concentration of the p-type emitter is 2×10¹⁸ atoms/cm³ - 1×10¹⁹ atoms/cm³, such as 2×10¹⁸ atoms/cm³, 3×10¹⁸ atoms/cm³, 4×10¹⁸ atoms/cm³, 5×10¹⁸ atoms/cm³, 6×10¹⁸ atoms/cm³, 7×10¹⁸ atoms/cm³, 8×10¹⁸ atoms/cm³, 9×10¹⁸ atoms/cm³, 1×10¹⁹ atoms/cm³, or within the range of any two of the above values. The moderate doping concentration of the p-type emitter can improve the electrical performance of the p-type emitter, not only forming a good junction structure, but also avoiding carrier recombination caused by excessive doping.

In some examples, the junction depth of the p-type emitter is 0.5 µm - 2 µm, such as 0.5 µm, 0.6 µm, 0.7 µm, 0.8 µm, 0.9 µm, 1 µm, 1.1 µm, 1.2 µm, 1.3 µm, 1.4 µm, 1.5 µm, 1.6 µm, 1.7 µm, 1.8 µm, 1.9 µm, 2 µm, or within the range of any two of the above values. The above junction depth can optimize the collection efficiency of carriers and reduce the recombination loss in the junction region, thereby improving the open-circuit voltage and overall performance of the cell.

In some examples, the tunnel oxide layer comprises one or more of silicon oxide, silicon nitride, and aluminum oxide, and/or the thickness of the tunnel oxide layer is 0.5 nm-2.5 nm. Selecting tunnel oxide layers of different materials or thicknesses can adjust their conductivity and dielectric properties, thereby adaptively improving the photoelectric conversion efficiency and stability of the cell.

In some examples, the thickness of the n-type doped polysilicon layer is 100 nm-300 nm, such as 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, or within the range of any two of the above values. The n-type doped polysilicon layer within this thickness range helps to improve the passivation effect and dielectric effect and reduce the contact resistance of the metal electrode as much as possible, thereby improving the efficiency and reliability of the cell.

In some examples, the doping concentration of the n-type doped polysilicon layer is 3×10²⁰ atoms/cm³ - 1×10²¹ atoms/cm³, such as 3×10²⁰ atoms/cm³, 4×10²⁰ atoms/cm³, 5×10²⁰ atoms/cm³, 6×10²⁰ atoms/cm³, 7×10²⁰ atoms/cm³, 8×10²⁰ atoms/cm³, 9×10²⁰ atoms/cm³, 1×10²¹ atoms/cm³, or within the range of any two of the above values.

In some embodiments, the first passivation layer and the second passivation layer each independently comprise at least one of aluminum oxide, silicon oxide, gallium oxide, silicon nitride, aluminum nitride, or silicon oxynitride. The use of the above materials helps to reduce surface defects and recombination, improve the stability and efficiency of the cell, and especially enhance the surface passivation effect to avoid current recombination loss.

In some embodiments, the first electrode and the second electrode each independently comprise at least one of silver, silver alloy, copper, copper alloy, nickel/copper/silver multi-layer electrode. The above metal materials can ensure good conductivity, stability, and corrosion resistance of the electrodes during long-term use, thereby optimizing the current conduction performance and efficiency of the cell.

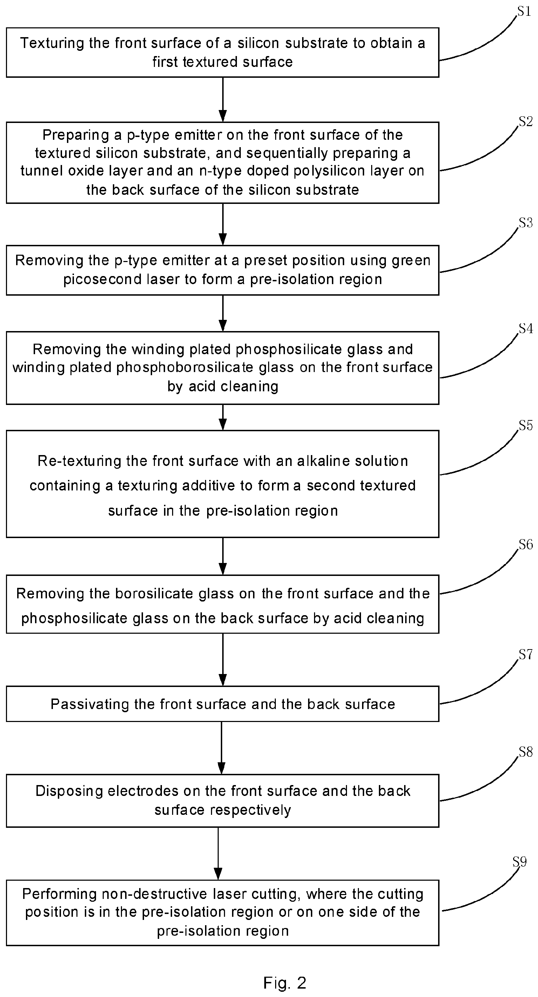

A second embodiment of the present application is to provide a method for preparing a solar cell, which, as shown in Figure 2, comprises the following steps:
S1: Texturing the front surface of a silicon substrate to obtain a first textured surface;
S2: Preparing a p-type emitter on the front surface of the textured silicon substrate, and sequentially preparing a tunnel oxide layer and an n-type doped polysilicon layer on the back surface of the silicon substrate;
S3: Removing the p-type emitter at a preset position using green picosecond laser to form a pre-isolation region;
S4: Removing the winding plated phosphosilicate glass and winding plated phosphoborosilicate glass on the front surface by acid cleaning;
S5: Re-texturing the front surface with an alkaline solution containing a texturing additive to form a second textured surface in the pre-isolation region;
S6: Removing the borosilicate glass on the front surface and the phosphosilicate glass on the back surface by acid cleaning;
S7: Passivating the front surface and the back surface;
S8: Disposing electrodes on the front surface and the back surface respectively;
S9: Performing non-destructive laser cutting, where the cutting position is in the pre-isolation region or on one side of the pre-isolation region;

wherein, the reflectivity of the first textured surface is R1, the reflectivity of the second textured surface is R2, the ratio R1/R2 ranges from 0.3 to 3, and
the distance between the substrate of the first textured surface and the substrate of the second textured surface ranges from 3 µm to 10 µm.

In the above preparation method, the pre-isolation region formed by using green picosecond laser in step S3 cuts off the p-n junction, isolating the emitters on both sides of the isolation region, which provides space for subsequent electrode isolation and cutting. Compared with nanosecond laser, green picosecond laser can more thoroughly remove the p-type emitter in the pre-isolation region without residual p-type emitter, which can expand the processing window of the isolation region. Therefore, during the alkaline solution treatment in step S5, there is no need to remove the remaining p-type emitter in the pre-isolation region, instead, it is only necessary to use the alkaline solution to remove the winding plated n-type doped polysilicon on the front surface. At the same time, since there is no blocking of the p-type emitter in the pre-isolation region, the alkaline solution can also remove the borosilicate melt and laser damage generated in the pre-isolation region, and texture the pre-isolation region to increase the etching depth of the pre-isolation region and obtain the second textured surface, thereby reducing the light reflectivity of the isolation region, i.e., increasing the light absorption rate of the isolation region, and effectively improving the short-circuit current. The above steps cooperate with each other, which not only realizes the regional regulation of the reflectivity of the isolation region and the working region, increases the light absorption rate of the isolation region, but also avoids damage to the p-type emitter in the working region, thereby effectively improving the short-circuit current. In addition, the first textured surface and the second textured surface effectively improve the open-circuit voltage of the cell. The overall preparation method is efficient and convenient, which is conducive to mass production. Meanwhile, since the isolation region can form a controllable pyramid structure after texturing, it has higher light utilization efficiency for non-destructive laser cutting. Compared with other structures, the power of non-destructive laser cutting can be further reduced, making the cutting damage more controllable.

The above preparation method is described below according to the operation order of the steps.

First, step S1 is operated: texturing the front surface of a silicon substrate to obtain the first textured surface. The first textured surface obtained in step S1 can enhance light-trapping capability and reduce reflection loss.

Step S2 is operated: preparing the p-type emitter on the front surface of the textured silicon substrate, and sequentially preparing the tunnel oxide layer and the n-type doped polysilicon layer on the back surface of the silicon substrate. The methods of preparing the p-type emitter, the tunnel oxide layer, and the n-type doped polysilicon layer can be referred to conventional techniques and will not be repeated here.

The p-type emitter prepared on the front surface in the step S2 forms a p-n junction, while the tunnel oxide layer and the n-type doped polysilicon layer prepared on the back surface form a passivated contact structure, which improves carrier selectivity.

Step S3 is operated: removing the p-type emitter at a preset position using green picosecond laser to form the pre-isolation region.

In some embodiments, the wavelength of the green picosecond laser is 532 nm or 1064 nm. A picosecond laser refers to a laser with a pulse duration at the picosecond level (10⁻¹² s). Due to its extremely short pulse duration, the picosecond laser has higher peak power and can focus and release a large amount of energy in an extremely short time, thereby achieving a very efficient etching effect on the p-type emitter in the pre-isolation region with less thermal damage and mechanical damage.

In some embodiments, the radiant power of the green picosecond laser ranges from 1 W to 50 W, such as 1 W, 2 W, 3 W, 4 W, 5 W, 6 W, 7 W, 8 W, 9 W, 10 W, 15 W, 20 W, 25 W, 30 W, 35 W, 40 W, 45 W, 50 W, or within the range of any two of the above values.

In some embodiments, the spot overlap rate of the green picosecond laser ranges from 40% to 80%, such as 40%, 50%, 60%, 70%, 80%, or within the range of any two of the above values. It should be noted that the control of the spot overlap rate of the green picosecond laser in the above embodiments is mainly intended to improve the working efficiency of laser processing, and is not intended to form a textured surface in the isolation region.

In some embodiments, the energy density of the green picosecond laser ranges from 100 mJ/cm² to 400 mJ/cm², such as 100 mJ/cm², 150 mJ/cm², 200 mJ/cm², 250 mJ/cm², 300 mJ/cm², 350 mJ/cm², 400 mJ/cm², or within the range of any two of the above values. The radiant power, spot overlap rate, and energy density within the above ranges enable higher-precision processing with low thermal damage, while balancing efficiency and quality.

Step S4 is operated: removing the winding plated phosphosilicate glass and winding plated phosphoborosilicate glass on the front surface by acid cleaning.

In some embodiments, the acid solution used for acid cleaning in the step S4 is an HF solution having a concentration of 5%-30%, such as 5%, 7%, 8%, 9%, 10%, 15%, 20%, 25%, 30%, or within the range of any two of the above values. This concentration range can effectively dissolve the phosphosilicate glass and phosphoborosilicate glass on the silicon wafer surface while avoiding excessive corrosion of the silicon substrate, thereby maintaining the flatness and electrical properties of the silicon wafer surface.

In some embodiments, the acid cleaning time in the step S4 ranges from 10 s to 70 s, such as 10 s, 20 s, 30 s, 40 s, 50 s, 60 s, 70 s, or within the range of any two of the above values. Proper time control ensures the complete removal of phosphosilicate glass or phosphoborosilicate glass while preventing excessive corrosion of the silicon wafer surface, thus maintaining good surface morphology and electrical properties.

Step S5 is operated: re-texturing the front surface with the alkaline solution containing the texturing additive to form the second textured surface in the pre-isolation region.

In some embodiments, the alkaline solution used for texturing in step S5 is not particularly limited, as long as its alkaline etching properties can form a textured structure on the silicon wafer surface. In preferred embodiments, the alkaline solution used for texturing in the step S5 is a NaOH or KOH solution. Compared with other alkaline solutions, NaOH or KOH has the characteristics of stable reaction rate and strong crystal orientation-selective etching, which can effectively avoid textured surface collapse or metal contamination caused by excessive corrosion.

In some embodiments, the texturing additive used for texturing in the step S5 is not particularly limited, as long as it can form a textured structure on the silicon wafer surface together with the alkaline solution. Common texturing additives comprise surfactants (e.g., isopropanol, ethanol), corrosion inhibitors (e.g., sodium silicate, sodium gluconate), complexing agents (e.g., EDTA), and pH regulators (e.g., acetic acid).

In some implementations, the mass ratio of the alkali to the texturing additive in the alkaline solution ranges from 1:2 to 5:1, such as 1:2, 1:1, 2:1, 3:1, 4:1, 5:1, or within the range of any two of the above ratios. The mass ratio of the alkali to the texturing additive affects the chemical activity and reaction selectivity of the texturing solution. The above appropriate ratio can balance the etching rate and textured surface uniformity, resulting in a more uniform textured surface.

In some embodiments, the texturing temperature ranges from 65°C to 85°C, such as 65°C, 66°C, 67°C, 68°C, 69°C, 70°C, 71°C, 72°C, 73°C, 74°C, 75°C, 76°C, 77°C, 78°C, 79°C, 80°C, 81°C, 82°C, 83°C, 84°C, 85°C, or within the range of any two of the above values. Temperature is a key parameter controlling reaction kinetics and textured surface morphology. Within the above temperature range, the etching rate of silicon by the alkali and the directional regulation effect of the additive are balanced, which is conducive to the formation of a uniform textured surface.

In some embodiments, the texturing time ranges from 600 s to 900 s, such as 600 s, 700 s, 800 s, 900 s, or within the range of any two of the above values. The time parameter determines the integrity and size distribution of the textured structure. The above time range can make the reaction carried out more thoroughly, and the resulting texture size is within an appropriate range.

Step S6 is operated: removing the borosilicate glass on the front surface and the phosphosilicate glass on the back surface by acid cleaning.

Step S7 is operated: passivating the front surface and the back surface. The passivation treatment in step S7 can reduce the surface recombination rate and improve the open-circuit voltage.

In some embodiments, the reflectivity of the first textured surface after passivation ranges from 7% to 15%, such as 7%, 8%, 9%, 10%, 11%, 12%, 13%, 14%, 15%, or within the range of any two of the above values. The low-reflectivity design of the first textured surface after passivation can reduce the surface reflection loss of incident light, especially enhance the absorption of long-wavelength light, thereby improving the short-circuit current.

In some embodiments, the reflectivity of the second textured surface after passivation ranges from 7% to 30%, such as 7%, 8%, 9%, 10%, 11%, 12%, 13%, 14%, 15%, 16%, 17%, 18%, 19%, 20%, 21%, 22%, 23%, 24%, 25%, 26%, 27%, 28%, 29%, 30%, or within the range of any two of the above values. Controlling the reflectivity of the second textured surface after passivation within the above range not only achieves passivation contact performance, but also optimizes light utilization efficiency, while avoiding process instability caused by extreme reflectivity.

In some embodiments, the distance between two adjacent emitters after the formation of the pre-isolation region ranges from 10 µm to 1000 µm, such as 10 µm, 20 µm, 30 µm, 40 µm, 50 µm, 60 µm, 70 µm, 80 µm, 90 µm, 100 µm, 200 µm, 300 µm, 400 µm, 500 µm, 600 µm, 700 µm, 800 µm, 900 µm, 1000 µm, or within the range of any two of the above values. This width range design balances the isolation effect, passivation effect, and light utilization efficiency of the pre-isolation region, and improves the alignment of subsequent cutting, thereby optimizing the module efficiency, and simultaneously meeting the requirements for voltage resistance, appearance, and quality reliability in different application scenarios.

Step S8 is operated: disposing electrodes on the front surface and the back surface respectively. The electrodes can be formed by disposing a silver paste via screen printing and the like, followed by curing and sintering.

Step S9 is operated: performing non-destructive laser cutting, where the cutting position is in the pre-isolation region or on one side of the pre-isolation region. Conventional non-destructive laser cutting techniques can be referred to for this process. Moreover, since the isolation region in the present application has a better isolation effect, and at the same time, the isolation region can form a controllable pyramid structure after texturing, it has higher light utilization efficiency for non-destructive laser cutting. Compared with other structures, the power of non-destructive laser cutting can be further reduced, making the cutting damage more controllable.

### [Examples]

Examples of the present application are described below. The following examples are illustrative, and are only used to explain the present application, but shall not be construed as limiting the present application. For those examples where specific technologies or conditions are not specified, they shall be conducted in accordance with the technologies or conditions described in the literatures in the art or in accordance with the product specifications. For reagents or instruments whose manufacturers are not specified, they are all conventional products commercially available.

### Test methods:

Under standard test conditions (STC: AM1.5G spectrum, 1000 W/m² light intensity, 25°C), the measurement methods and corresponding standards for various parameters are as follows:
With the use of a steady-state IV tester, by directly measuring the open circuit voltage (Voc) and short-circuit current (Isc), and scanning the IV curve, the maximum power point was calculated, and the photoelectric conversion efficiency (pEFF) was measured and calculated according to ASTM E948 standard;
With the use of a WCT120-Suns Voc detector, by generating and fitting a Suns-Voc curve, Pseudo fill factor (pFF) was obtained according to ASTM E1036, and base diffusion current (J01) and junction recombination current (J02) were obtained through Suns-Voc technical analysis.

### Example 1

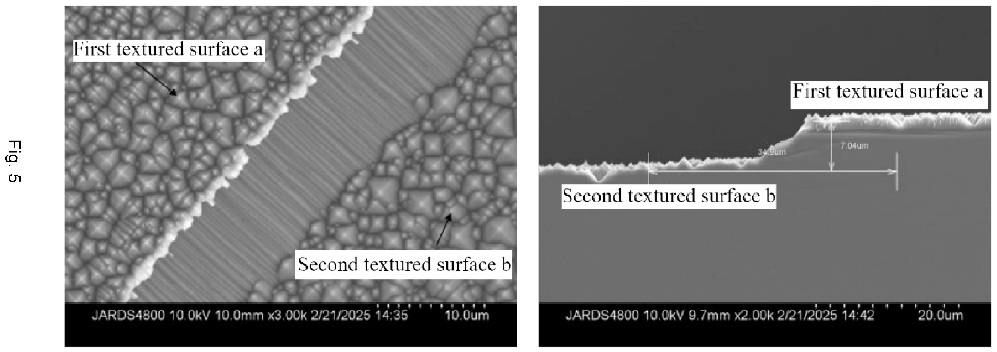

A solar cell was prepared according to the following steps:
Step S1: An n-type silicon wafer with a resistivity of 1 Ω·cm and a thickness of 130 µm was subjected to texturing treatment to obtain a first textured surface a, with a reflectivity of 9%.
Step S2: Subsequently, the silicon wafer was loaded into a high-temperature tube diffusion furnace, and boron trichloride (BCl₃) was introduced to complete the boron diffusion process. At this time, a P+ emitter and borosilicate glass (BSG) were formed on the surface of the silicon wafer; then, a HF acid having a concentration of 40% was used for single-surface etching to remove the BSG on the back surface of the cell. After that, a KOH solution having a concentration of 10% and a polishing additive (Shichuang NI10V01) were used to polish the back surface of the cell. The front surface of the cell was protected by BSG, so its morphology and structure remained unchanged; immediately afterwards, 20,000 sccm of oxygen was introduced at 600°C to grow a 1 nm-thick tunnel oxide layer through thermal oxidation. Then, silane was introduced at 620°C by low-pressure chemical vapor deposition (LPCVD) to grow a 200 nm-thick intrinsic polysilicon (i-Poly Si) layer. Subsequently, phosphorus trichloride was used as the phosphorus source for phosphorus diffusion at 900°C. After phosphorus diffusion, an n-type doped polysilicon layer and phosphosilicate glass (PSG) were formed on the surface, and winding plated PSG and PBSG (phosphoborosilicate glass) were formed on the front surface.
Step S3: Subsequently, a green picosecond laser was used to perform laser etching on the preset laser cutting area on the front surface to remove the P emitter. The laser wavelength is 532 nm, with set parameters as follows: power of 20 W, frequency of 1000 kHz, spot overlap rate of 60%, energy density of 200 mJ/cm², and isolation region width of 400 µm.
Step S4: Immediately afterwards, acid cleaning was performed with a HF acid having a concentration of 20% for 40 s to remove the winding plated PSG/PBSG on the front surface.
Step S5: Subsequently, the front surface of the cell was re-textured using a NaOH solution having a concentration of 10% (the concentration of texturing additive (Shichuang ST10V18) being 2% in the NaOH solution) at a temperature of 68°C for a reaction time of 900 s, obtaining a second textured surface b. As shown in Figure 1, the reflectivity of the second textured surface b was 15%, the reflectivity ratio of the first textured surface a to the second textured surface b was 3:5, and the distance between the substrates of the first textured surface and the second textured surface was 7 µm. At this time, the back surface of the silicon wafer was protected by PSG, and the P+ region on the front surface was protected by BSG, without damage.
Step S6: Finally, a HF solution having a concentration of 10% was used to remove the BSG on the front surface and the PSG on the back surface.
Step S7: Subsequently, the front surface of the silicon wafer was coated with Al₂O₃. At 250°C, trimethylaluminum and water were introduced to grow a 6 nm-thick Al₂O₃ layer on both the front and back surfaces. Immediately afterwards, in a plasma-enhanced chemical vapor deposition device, silane and ammonia gas were introduced at 540°C to complete the deposition of SiNₓ thin films on both the front and back surfaces, with a thickness of 75 nm each.
Step S8: Subsequently, a silver paste was screen-printed on the P emitter and n-type doped polysilicon layer region of the cell respectively, followed by high-temperature sintering to complete metallization. Finally, after light injection treatment, a TOPCon cell was obtained. The schematic cross-sectional structure diagram of the TOPCon cell is shown in Figure 1. The morphological planar images and cross-sectional images of the first textured surface and the second textured surface b of the TOPCon cell, captured by a scanning electron microscope (SEM), are shown in Figure 5.

### Example 2

The difference from Example 1 lies in Step S5: the reaction time for re-texturing the front surface of the cell was 550 s to obtain a second textured surface. The reflectivity of the first textured surface was measured to be 9%, the reflectivity of the second textured surface was 30%, the reflectivity ratio of the first textured surface to the second textured surface was 0.3, the distance between the substrates of the first textured surface and the second textured surface was 7.5 µm, and the width of the isolation region was 400 µm.

### Example 3

The differences from Example 1 are as follows: in Step S1, the n-type silicon wafer was subjected to texturing treatment to obtain a first textured surface with a reflectivity of 15%; in Step S5, the concentration of the texturing additive in the 10% NaOH solution was 3.33%, and the reaction time for re-texturing the front surface of the cell was 900 s to obtain a second textured surface. The reflectivity of the second textured surface was measured to be 8%, the reflectivity ratio of the first textured surface to the second textured surface was 1.875, the distance between the substrates of the first textured surface and the second textured surface was 7.4 µm, and the width of the isolation region was 400 µm.

### Comparative Example 1

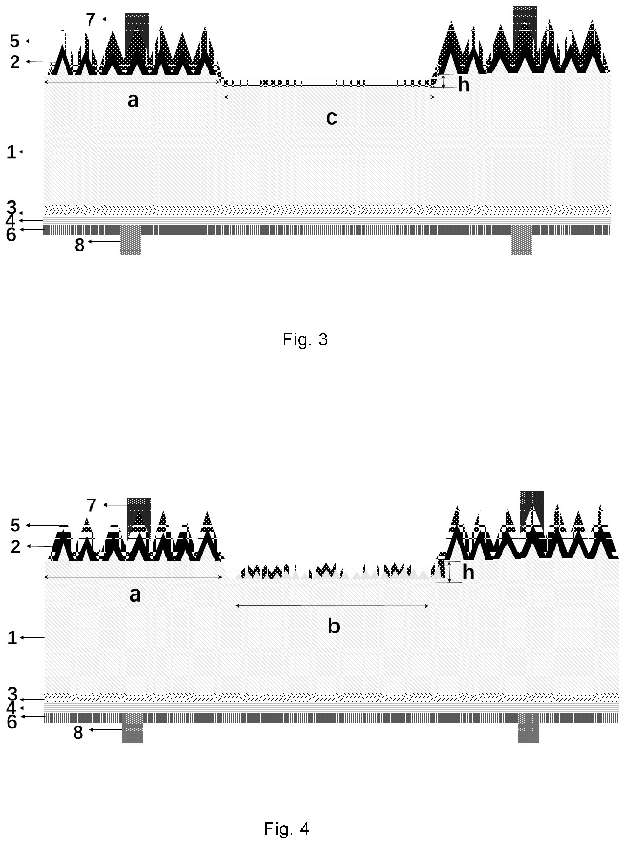

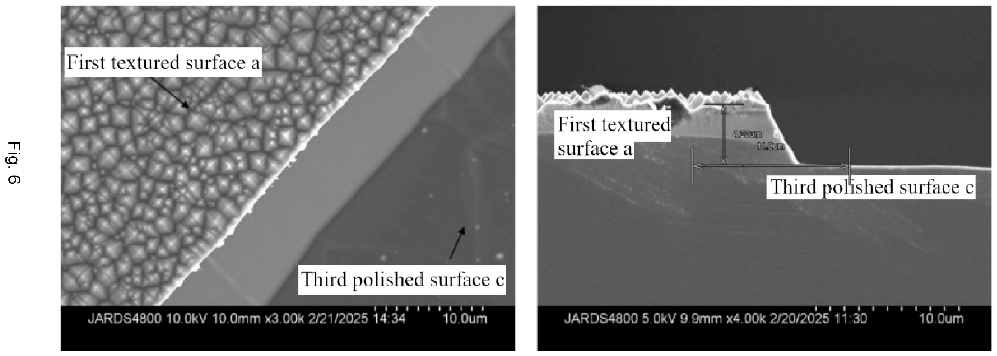

The difference from Example 1 lies in Step S5: the reaction time for re-texturing the front surface of the cell was 400 s to obtain a second textured surface b. The reflectivity of the first textured surface a was measured to be 8.8%, the reflectivity of the second textured surface b was 50%, the reflectivity ratio of the first textured surface a to the second textured surface b was 0.176, the distance between the substrates of the first textured surface and the second textured surface was 4.3 µm, and the width of the isolation region was 400 µm. The schematic cross-sectional structure diagram of the obtained TOPCon cell is shown in Figure 3. The morphological planar images and cross-sectional images of the first textured surface a and the second textured surface b of the TOPCon cell, captured by a scanning electron microscope (SEM), are shown in Figure 6.

### Comparative Example 2

The difference from Example 1 is that there was no re-texturing step of S5. The reflectivity of the first textured surface a was measured to be 9%, the reflectivity of the isolation region surface was 60%, the reflectivity ratio of the first textured surface a to the isolation region surface was 0.15, the distance between the substrates of the first textured surface and the isolation region surface was 3 µm, and the width of the isolation region was 380 µm.

### Comparative Example 3

The difference from Example 1 lies in Step S3: a nanosecond laser with a wavelength of 520 nm was used for etching to remove the P emitter, with the parameters set as follows: spot overlap rate of 50%, energy density of 10 J/cm², and pulse width of 10 ns. The reflectivity of the first textured surface was measured to be 10%, the reflectivity of the second textured surface was 20%, the reflectivity ratio of the first textured surface to the second textured surface was 0.5, the distance between the substrates of the first textured surface and the second textured surface was 11.5 µm, and the width of the isolation region was 600 µm.

### Comparative Example 4

The difference from Example 1 lies in Step S5: the reaction time for re-texturing the front surface of the cell was 1200 s to obtain a second textured surface. The reflectivity of the first textured surface was measured to be 9%, the reflectivity of the second textured surface was 2.8%, the reflectivity ratio of the first textured surface to the second textured surface was 3.21, the distance between the substrates of the first textured surface and the second textured surface was 11 µm, and the width of the isolation region was 700 µm.

The parameters pEFF, Voc, Isc, pFF, J01, and J02 of the TOPCon cells obtained in Example 1 and Comparative Examples 1-4 were measured, and the results are recorded in Table 1 below.

**Table 1**

| | Mean value: pEFF(%) | Mean value: Voc(V) | Mean value: Isc(A) | Mean value: pFF(%) | Mean value:J01 (A/cm²) | Mean value:J02 (A/cm²) |
|---|---|---|---|---|---|---|
| Example 1 | 26.25 | 0.7391 | 14.39 | 85.37 | 1.46E-14 | 1.66E-10 |
| Example 2 | 26.24 | 0.7397 | 14.15 | 85.50 | 1.48E-14 | 1.5E-10 |
| Example 3 | 26.27 | 0.739 | 14.41 | 85.40 | 1.51E-14 | 1.56E-10 |
| Comparative Example 1 | 25.98 | 0.7372 | 14.01 | 84.69 | 1.49E-14 | 2.92E-10 |
| Comparative Example 2 | 25.9 | 0.7383 | 13.88 | 84.93 | 1.47E-14 | 1.98E-10 |
| Comparative Example 3 | 25.75 | 0.7342 | 14.11 | 83.16 | 2.01E-14 | 5.16E-10 |
| Comparative Example 4 | 26.03 | 0.7353 | 14.48 | 83.88 | 1.88E-14 | 4.18E-10 |

The data in Table 1 shows that Examples 1-3 all achieved high pEFF, Voc, Isc, and pFF, as well as low J01 and J02, resulting in a photoelectric conversion efficiency exceeding 26.2%, demonstrating excellent performance. For Comparative Example 1, due to the short texturing time, the images in Figure 6 also show that almost no texturing was achieved, resulting in high reflectivity. This further led to an increase in defect recombination of J02, thereby reducing the overall photoelectric conversion efficiency. In Comparative Example 2 without texturing, Isc was significantly low, indicating that the decrease in carrier collection efficiency limited current output and thus reduced photoelectric conversion efficiency. In Comparative Example 3, a nanosecond laser with low peak power was used. Under this condition, J02 surged while J01 also increased significantly. This suggests that the possibly residual p-type emitter deteriorated the recombination mechanisms of both the diffusion layer and the space charge region, thereby significantly reducing photoelectric conversion efficiency. In Comparative Example 4 with excessively long texturing time, both J01 and J02 increased. This indicates that excessive corrosion of the isolation region surface may have occurred, which further intensified carrier recombination while impairing light absorption and carrier separation efficiency, leading to a decrease in photoelectric conversion efficiency.

The effects of laser power and energy density on solar cell performance were investigated below.

### Example 4

The difference from Example 1 lies in Step S3: the laser power was set to 30 W. The reflectivity of the first textured surface was measured to be 8.9%, the reflectivity of the second textured surface was 16%, the reflectivity ratio of the first textured surface to the second textured surface was 0.5563, the distance between the substrates of the first textured surface and the second textured surface was 6.8 µm, and the width of the isolation region was 395 µm.

### Example 5

The difference from Example 1 lies in Step S3: the laser energy density was set to 280 mJ/cm². The reflectivity of the first textured surface was measured to be 9.1%, the reflectivity of the second textured surface was 15.3%, the reflectivity ratio of the first textured surface to the second textured surface was 0.5948, the distance between the substrates of the first textured surface and the second textured surface was 7.5 µm, and the width of the isolation region was 420 µm.

The parameters pEFF, Voc, Isc, pFF, J01, and J02 of the TOPCon cells obtained in Examples 4 and 5 were measured, and the results are recorded in Table 2 below.

**Table 2**

| | Mean value: pEFF (%) | Mean value: Voc(V) | Mean value: Isc(A) | Mean value: pFF(%) | Mean value:J01 (A/cm²) | Mean value:J02 (A/cm²) |
|---|---|---|---|---|---|---|
| Example 1 | 26.25 | 0.7391 | 14.39 | 85.37 | 1.46E-14 | 1.66E-10 |
| Example 4 | 26.2 | 0.7394 | 14.31 | 85.3 | 1.39E-14 | 1.57E-10 |
| Example 5 | 26.17 | 0.7388 | 14.38 | 85.31 | 1.4E-14 | 1.61E-10 |

The data in Table 2 shows that the TOPCon cells prepared under the above conditions all exhibit a high level of photoelectric conversion efficiency (pEFF > 26%), and the performance results of each group are close, indicating good process stability.

The effect of acid cleaning conditions in Step S4 on solar cell performance was investigated below.

### Example 6

The difference from Example 1 lies in Step S4: acid cleaning was performed with an HF acid having a concentration of 5% for 70 s. The reflectivity of the first textured surface was measured to be 8.7%, the reflectivity of the second textured surface was 14.9%, the reflectivity ratio of the first textured surface to the second textured surface was 0.5839, the distance between the substrates of the first textured surface and the second textured surface was 6.8 µm, and the width of the isolation region was 405 µm.

### Example 7

The difference from Example 1 lies in Step S4: acid cleaning was performed with an HF acid having a concentration of 30% for 10 s. The reflectivity of the first textured surface was measured to be 9.4%, the reflectivity of the second textured surface was 15.1%, the reflectivity ratio of the first textured surface to the second textured surface was 0.6225, the distance between the substrates of the first textured surface and the second textured surface was 6.9 µm, and the width of the isolation region was 408 µm.

The parameters pEFF, Voc, Isc, pFF, J01, and J02 of the TOPCon cells obtained in Examples 6 and 7 were measured, and the results are recorded in Table 3 below.

**Table 3**

| | Mean value: pEFF (%) | Mean value: Voc (V) | Mean value: Isc(A) | Mean value: pFF(%) | Mean value:J01 (A/cm²) | Mean value:J02 (A/cm²) |
|---|---|---|---|---|---|---|
| Example 1 | 26.25 | 0.7391 | 14.39 | 85.37 | 1.46E-14 | 1.66E-10 |
| Example 6 | 26.27 | 0.7395 | 14.1 | 85.33 | 1.38E-14 | 1.59E-10 |
| Example 7 | 26.21 | 0.7389 | 14.35 | 85.2 | 1.5E-14 | 1.72E-10 |

The data in Table 3 shows that the performance data of each group for the TOPCon cells prepared under the above HF acid conditions are close, all of which can achieve high photoelectric conversion efficiency.

The effect of re-texturing conditions in Step S5 on solar cell performance was investigated below.

### Example 8

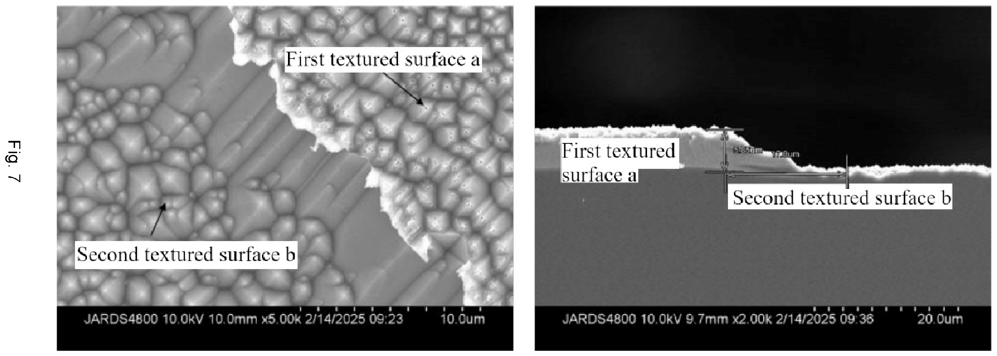

The difference from Example 1 lies in Step S5: the reaction time for re-texturing the front surface of the cell was 600 s to obtain a second textured surface. The reflectivity of the first textured surface was measured to be 9%, the reflectivity of the second textured surface was 21%, the reflectivity ratio of the first textured surface to the second textured surface was 3:7, and the distance between the substrates of the first textured surface and the second textured surface was 5.8 µm. The schematic cross-sectional structure diagram of the obtained TOPCon cell is shown in Figure 4. The morphological planar images and cross-sectional images of the first textured surface a and the second textured surface b of the TOPCon cell, captured by a scanning electron microscope (SEM), are shown in Figure 7.

### Example 9

The difference from Example 1 lies in Step S5: the concentration of the texturing additive in the 10% NaOH solution was 20%. The reflectivity of the first textured surface was measured to be 9.2%, the reflectivity of the second textured surface was 17%, the reflectivity ratio of the first textured surface to the second textured surface was 0.5412, the distance between the substrates of the first textured surface and the second textured surface was 7.6 µm, and the width of the isolation region was 410 µm.

### Example 10

The difference from Example 1 lies in Step S5: the re-texturing temperature was 65°C. The reflectivity of the first textured surface was measured to be 9.5%, the reflectivity of the second textured surface was 16.5%, the reflectivity ratio of the first textured surface to the second textured surface was 0.5758, the distance between the substrates of the first textured surface and the second textured surface was 6.3 µm, and the width of the isolation region was 395 µm.

### Example 11

The difference from Example 1 lies in Step S5: the re-texturing temperature was 85°C. The reflectivity of the first textured surface was measured to be 8.7%, the reflectivity of the second textured surface was 14.8%, the reflectivity ratio of the first textured surface to the second textured surface was 0.5878, the distance between the substrates of the first textured surface and the second textured surface was 7.1 µm, and the width of the isolation region was 410 µm.

The parameters pEFF, Voc, Isc, pFF, J01, and J02 of the TOPCon cells obtained in Examples 8-11 were measured, and the results are recorded in Table 4 below.

**Table 4**

| | Mean value: pEFF (%) | Mean value: Voc(V) | Mean value: Isc(A) | Mean value: pFF(%) | Mean value:J01 (A/cm²) | Mean value:J02 (A/cm²) |
|---|---|---|---|---|---|---|
| Example 1 | 26.25 | 0.7391 | 14.39 | 85.37 | 1.46E-14 | 1.66E-10 |
| Example 8 | 26.12 | 0.7384 | 14.21 | 85.01 | 1.52E-14 | 2.14E-10 |
| Example 9 | 26.23 | 0.7392 | 14.3 | 85.27 | 1.42E-14 | 1.64E-10 |
| Example 10 | 26.28 | 0.7393 | 14.33 | 85.29 | 1.39E-14 | 1.93E-10 |
| Example 11 | 26.3 | 0.7396 | 14.37 | 85.52 | 1.33E-14 | 1.54E-10 |

The data in Table 4 shows that the TOPCon cells prepared under the above conditions all exhibit a high level of photoelectric conversion efficiency. A comparison between Example 8 and Example 1 reveals that when the re-texturing time is shorter, the texturing of the second textured surface is reduced, leading to an increase in the reflectivity of the second textured surface and a decrease in the number of effective photo-generated carriers, which in turn causes a slight decrease in photoelectric conversion efficiency. The performance data of Examples 9-11 are close to that of Example 1, all of which can achieve high photoelectric conversion efficiency.

Although the specific embodiments of the present invention have been described in detail, those skilled in the art will understand that various modifications and substitutions can be made to these details based on all the teachings disclosed, and these changes are all within the protection scope of the present invention. The entire scope of the present invention is defined by the appended claims and any equivalents thereof.

## Claims

1. A solar cell, comprising a silicon substrate, wherein the front surface of the silicon substrate is provided with a textured structure, the front surface of the silicon substrate is divided into a working region and an edge isolation region, the working region comprises a p-type emitter, a first passivation layer and a first electrode which are sequentially arranged on the front surface from inside to outside, and the edge isolation region comprises the first passivation layer arranged on the front surface; a tunneling oxide layer, an n-type doped polysilicon layer, a second passivation layer and a second electrode are sequentially arranged on the back surface of the silicon substrate from inside to outside, wherein
the reflectivity of the textured structure in the working region is R1, the reflectivity of the textured structure in the edge isolation region is R2, R1/R2 is within the range of 0.3-3, and
the distance between the textured structure substrate of the working region and the textured structure substrate of the edge isolation region is within the range of 3 µm -10 µm.

2. The solar cell as claimed in claim 1, wherein, the reflectivity R1 is 7%-15%; and/or the reflectivity R2 is 7%-30%.

3. The solar cell as claimed in claim 1 or 2, wherein, the minimum dimension of the edge isolation region in the direction away from the working region ranges from 10 µm to 1000 µm.

4. The solar cell as claimed in claim 1 or 2, wherein, the edge isolation region is a rectangular region.

5. The solar cell as claimed in claim 1 or 2, wherein, the silicon substrate is an n-type silicon substrate.

6. The solar cell as claimed in claim 1 or 2, wherein, the silicon substrate is a phosphorus-doped monocrystalline silicon wafer.

7. The solar cell as claimed in claim 1 or 2, wherein, the resistivity of the silicon substrate is 0.1 Ω·cm-100 Ω·cm; and/or the thickness of the silicon substrate is 100 µm-500 µm.

8. The solar cell as claimed in claim 1 or 2, wherein, the doping concentration of the p-type emitter is 2×10¹⁸ atoms/cm³-1×10¹⁹ atoms/cm³; and/or the junction depth of the p-type emitter is 0.5 µm-2 µm.

9. The solar cell as claimed in claim 1 or 2, wherein, the tunnel oxide layer comprises one or more of silicon oxide, silicon nitride, and aluminum oxide, and/or the thickness of the tunnel oxide layer is 0.5 nm-2.5 nm.

10. The solar cell as claimed in claim 1 or 2, wherein, the thickness of the n-type doped polysilicon layer is 100 nm-300 nm; and/or
the doping concentration of the n-type doped polysilicon layer is 3×10²⁰ atoms/cm³-1×10²¹ atoms/cm³.

11. The solar cell as claimed in claim 1 or 2, wherein, the first passivation layer and the second passivation layer each independently comprise at least one of aluminum oxide, silicon oxide, gallium oxide, silicon nitride, aluminum nitride, or silicon oxynitride.

12. The solar cell as claimed in claim 1 or 2, wherein, the first electrode and the second electrode each independently comprise at least one of silver, silver alloy, copper, copper alloy, nickel/copper/silver multi-layer electrode.

13. A method for preparing a solar cell, comprising the following steps:
S1: Texturing the front surface of a silicon substrate to obtain a first textured surface;
S2: Preparing a p-type emitter on the front surface of the textured silicon substrate, and sequentially preparing a tunnel oxide layer and an n-type doped polysilicon layer on the back surface of the silicon substrate;
S3: Removing the p-type emitter at a preset position using green picosecond laser to form a pre-isolation region;
S4: Removing the winding plated phosphosilicate glass and winding plated phosphoborosilicate glass on the front surface by acid cleaning;
S5: Re-texturing the front surface with an alkaline solution containing a texturing additive to form a second textured surface in the pre-isolation region;
S6: Removing the borosilicate glass on the front surface and the phosphosilicate glass on the back surface by acid cleaning;
S7: Passivating the front surface and the back surface;
S8: Disposing electrodes on the front surface and the back surface respectively;
S9: Performing non-destructive laser cutting, where the cutting position is in the pre-isolation region or on one side of the pre-isolation region;
wherein, the reflectivity of the first textured surface is R1, the reflectivity of the second textured surface is R2, the ratio R1/R2 ranges from 0.3 to 3, and
the distance between the substrate of the first textured surface and the substrate of the second textured surface ranges from 3 µm to 10 µm.

14. The method as claimed in claim 13, wherein, the green picosecond laser satisfies one or more of the following conditions:
1) the wavelength of the green picosecond laser is 532 nm or 1064 nm;
2) the radiant power of the green picosecond laser is 1 W-50 W;
3) the spot overlap rate of the green picosecond laser is 40%-80%; or
4) the energy density of the green picosecond laser is 100 mJ/cm²-400 mJ/cm².

15. The method as claimed in claim 13 or 14, wherein, the reflectivity of the first textured surface is 7%-15%, and/or the reflectivity of the second textured surface is 7%-30%.

16. The method as claimed in claim 13 or 14, wherein, the distance between two adjacent emitters after the formation of the pre-isolation region ranges from 10 µm to 1000 µm.

17. The method as claimed in claim 13 or 14, wherein, in the step S4, the acid solution used for acid cleaning is an HF solution having a concentration of 5%-30%, and the acid cleaning time is 10 s-70 s.

18. The method as claimed in claim 13 or 14, wherein, the step S5 satisfies one or more of the following conditions:
1) the mass ratio of the alkali to the texturing additive in the alkaline solution is 1:2-5:1;
2) the texturing temperature is 65°C-85°C;
3) the texturing time is 600 s-900 s.
